(19) **Europäisches Patentamt**
**European Patent Office**
**Office européen des brevets**

(11) **EP 2 039 008 B1**

(12) **EUROPÄISCHE PATENTSCHRIFT**

(45) Veröffentlichungstag und Bekanntmachung des Hinweises auf die Patenterteilung:
**26.01.2011 Patentblatt 2011/04**

(51) Int Cl.:
*H03M 1/50* (2006.01)   *G01R 25/00* (2006.01)
*G04F 10/00* (2006.01)

(21) Anmeldenummer: **07764702.2**

(22) Anmeldetag: **18.06.2007**

(86) Internationale Anmeldenummer:
**PCT/EP2007/005353**

(87) Internationale Veröffentlichungsnummer:
**WO 2008/003397 (10.01.2008 Gazette 2008/02)**

(54) **VORRICHTUNG UND VERFAHREN FÜR HOCHAUFLÖSENDE ZEITMESSUNGEN**

DEVICE AND METHOD FOR HIGH RESOLUTION TIME MEASUREMENTS

SYSTÈME ET PROCÉDÉ POUR OBTENIR DES MESURES DE TEMPS À HAUTE RÉSOLUTION

(84) Benannte Vertragsstaaten:
**DE FR GB**

(30) Priorität: **07.07.2006 DE 102006031558**
**17.07.2006 DE 102006032962**

(43) Veröffentlichungstag der Anmeldung:
**25.03.2009 Patentblatt 2009/13**

(73) Patentinhaber: **Rohde & Schwarz GmbH & Co. KG**
**81671 München (DE)**

(72) Erfinder: **JANOT, Stephan**
**81827 München (DE)**

(74) Vertreter: **Körfer, Thomas et al**
**Mitscherlich & Partner**
**Patent- und Rechtsanwälte**
**Postfach 33 06 09**
**80066 München (DE)**

(56) Entgegenhaltungen:
**EP-A- 0 529 875   EP-A- 1 496 410**

EP 2 039 008 B1

**Beschreibung**

Die Erfindung betrifft ein System und ein Verfahren für hochauflösende Zeitmessungen in Systemen mit begrenzter Bandbreite.

Zunächst wird der grundsätzliche Aufbau eines Zeitmesssystems für hochauflösende Zeitmessungen erläutert. Es wird kurz erläutert, in welchem Zusammenhang die zeitliche Auflösung eines Systems zu dessen Bandbreite steht. Anschließend wird die Problematik bisheriger Messverfahren bezüglich einer endlichen Steilheit von Triggerflanken und einer gewünschten hohen zeitlichen Auflösung angeführt. Anschließend wird das zu patentierende Verfahren der Realisierung einer hochauflösenden Zeitmessung bei relativ flachen Triggersignalflanken erläutert. Hierzu gibt es sowohl eine theoretische Herleitung der zu erwartenden Eigenschaften dieses Verfahrens, als auch eine Ausführung der Realisierung.

Zum technischen Hintergrund wird auf die US 2005/0024120 A1 verwiesen, aus der eine Vorrichtung zur Steuerung eines Dual-Slope Integrators hervorgeht.

Aus der EP 0 529 875 A2 sind ein Verfahren und eine Vorrichtung zum Bestimmen der zeitlichen Lage eines analogen Triggersignals in Bezug auf ein analoges Taktsignal bekannt. Das analoge Triggersignal wird aufbereitet, indem es verzögert wird. Das analoge Taktsignal wird aufbereitet, indem es in seine Realteil-Komponente und seine Imaginärteil-Komponente zerlegt wird.

Aus der EP 1 496 410 A1 ist ein Verfahren und eine Vorrichtung zum Bestimmen der zeitlichen Lage eines empfangenen analogen Signals in Bezug auf ein analoges Referenzsignal bekannt. Es wird zwar eine analoge Kreuzkorrelation jedoch ohne analoge komplexe Mischung durchgeführt.

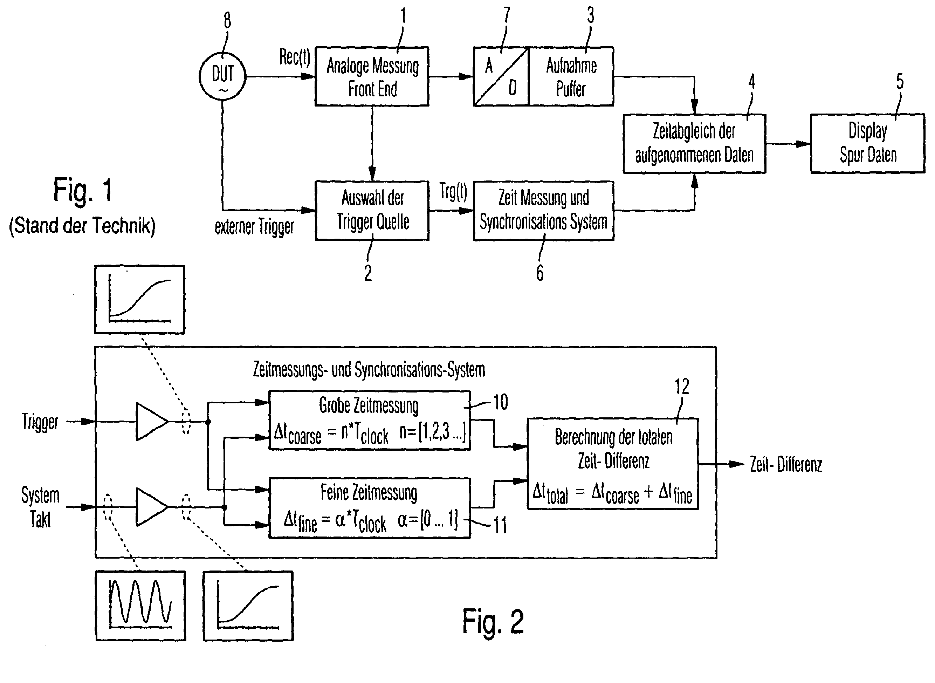

In einer Vielzahl von Messsystemen besteht die Anforderung den genauen Zeitpunkt des Auftretens eines bestimmten Ereignisses in einem empfangenen Signal zu bestimmen, bzw. ein empfangenes Signal in zeitlichem Bezug zu einem Triggerereignis auszuwerten. In einem solchen in Fig. 1 gezeigten Messsystem werden das empfangene Signal [rec(t)] einer zu vermessenden Signalquelle (DUT) 8 über ein analoges Empfangsteil (Frontend) 1 empfangen. Anschließend werden die Daten in einem A/D-Wandler 7 analog/digital gewandelt (A/D) und in einem Erfassungsspeicher 3 abgelegt. Die Erfassung der Daten erfolgt in vielen Fällen ununterbrochen in einem Ringspeicher. Die Daten werden anschließend zumeist an einem Bildschirm 5 dargestellt. Hierbei ist wichtig, dass der zeitliche Abstand zu einem externen Triggersignal bzw. zu einer Triggerflanke innerhalb des empfangenen Signals bekannt ist. Diese Zeit wird während der Datenaufnahme fortlaufend gemessen und kann dann vor der Darstellung der Ergebnisse durch das richtige Ausrichten der Daten im Speicher 3 berücksichtigt werden.

Die geforderte Auflösung einer solchen Zeitmessung hängt wesentlich von der Bandbreite des Messsystems ab. Bei periodisch wiederkehrenden Signalen wird erwartet, dass die Aufnahme bzw. das Auswerten empfangener Daten immer zum gleichen Zeitpunkt bezogen auf ein Triggerereignis erfolgt oder eine gewählte Flanke des Signals erfolgt. Werden periodisch wiederkehrende Messdaten graphisch als Kurven dargestellt, so führt eine ungenaue zeitliche Synchronisation zu einem Schwanken (Jitter) der angezeigten Kurve auf dem Bildschirm 5. Um ein für das menschliche Auge wenig wahrnehmbares Schwanken der Kurve zu realisieren, ist eine zeitliche Auflösung von weniger als 1% der Periodendauer ($T_{signal}$) des Signals erforderlich. Die minimale Periodendauer ($T_{signal}$) eines darstellbaren Signals hängt von der Bandbreite ($BW_{signal}$) des Meßsystems ab.

Die geforderte zeitliche Auflösung $dt_{resolution}$ eines Zeitmesssystems muss kleiner als 1/100 der Periodendauer des gemessenen Signals sein. Damit folgt für die Bandbreite des Zeitermesssystems, dass dessen Bandbreite $BW_{resolution}$ größer als das Hundertfache der empfangenen Signalbandbreite sein müsste. In Messsystemen mit hoher Signalbandbreite stößt man hier oft an die Grenzen der verwendeten Bauteile. Das Ziel der meisten Entwicklungen ist es, die Signalbandbreite so groß wie möglich zu machen. Dieses führt zu Miniaturisierung der Bauteile bzw. zu einer Integration der Funktionalität in einem Halbleiterchip. Wird ein Messsystem in einem integrierten Schaltkreis realisiert, so ist die Signalbandbreite meist durch die verwendete Halbleitertechnologie begrenzt. Soll nun noch ein Zeiterfassungssystem mit der geforderten Auflösung von 1% der kleinsten Signalperiode realisiert werden, so übersteigt die dafür benötige Bandbreite $BW_{resolution}$ zumeist die Möglichkeiten der Halbleitertechnologie um ein Vielfaches.

Um eine Zeitmessung zu realisieren, ist es zu nächst nötig, den Beginn und das Ende einer Messung genau feststellen zu können. Die Markierung des Beginns und des Endes der Zeitmessung erfolgt, wie in Fig. 2 dargestellt, üblicherweise durch Trigger- bzw. Systemtaktflanken. Die Steilheit einer solchen Flanke beeinflusst maßgeblich die Genauigkeit des Systems. So liegen bei den meisten Messkonzepten die Anstiegszeiten solcher Flanken in der Größenordnung der gewünschten zeitlichen Auflösung $dt_{resolution}$. Je flacher diese Flanke ist, desto ungenauer ist im Allgemeinen die Zeitmessung.

Basierend auf solch einer genauen Trigger- bzw. Taktflanke gibt es nun verschieden Möglichkeit eine Zeitmessung zu realisieren, auf die hier nicht näher eingegangen werden soll. Die meisten Verfahren basieren darauf, dass ein Trigger- oder Signalereignis gegen einen stabilen Systemtakt vermessen wird. Der Systemtakt bildet damit das Zeitnormal des Messsystems. Die Messung wird zumeist in zwei Messaufgaben unterteilt. Zum einen in einen in eine grobe Messung 10, die Zeitabstände in Vielfachen des Systemtakts vermisst, und in eine feine Messung 11, die Zeiten in Bruchteilen des Systemtakts vermessen soll. Das Auflösungsvermögen des Gesamtsystems wird hier ausschließlich durch die feine Zeitmessung 11 bestimmt. Die Eigenschaften dieser feinen Zeitmessung 11 hängen nun stark von der Signalform der Trigger- bzw. Systemtaktflanke am Eingang ab. Die Berechnung der Gesamt-Differenzen erfolgt in der Einheit 12.

Hier besteht das Problem darin, hochgenaue und schnelle Trigger- bzw. Systemtaktflanken zu erzeugen, deren zeitlicher Abstand exakt vermessen werden kann. In einem System mit 10GHz Signalbandbreite ist nach obigen Ausführungen die Auflösung der Zeitmessung von weniger als 1ps gefordert:

$$dt_{resolution} \leq \frac{T_{signal}}{100} = \frac{1}{100 \cdot BW_{signal}} = \frac{1}{10^{12}} = 1ps$$

Die Anstiegszeit der Trigger- bzw. Systemtaktflanken sollte hier zum Beispiel in der Größenordnung einer oder mehrerer ps liegen, aber im Allgemeinen einen Wert von 5ps nicht überschreiten. Dies würde nun zu Bandbreiten des Triggerbausteins in einer Größenordnung von 200 ... 1000 GHz führen. Mit den meisten der derzeitig verfügbaren Halbleitertechnologien sind solch hohe Bandbreiten nicht oder nur schwer erreichbar.

Aufgrund dieser technologischen Einschränkung besteht die Aufgabe darin, ein Messverfahren und eine Vorrichtung für die feine Zeitmessung zu schaffen, das bzw. die auch mit relativ langsamen Triggerflanken eine Zeitmessung mit hoher Auflösung ermöglichen. Die erforderliche Bandbreite des Messsystems soll hierbei in der gleichen Größenordnung wie die des Systemtakts liegen.

Die Aufgabe wird bezüglich des Messverfahrens durch die Merkmale des Anspruchs 1 und bezüglich der Vorrichtung durch die Merkmale des Anspruchs 8 gelöst.

Ziel der Erfindung ist die Realisierung eines Verfahrens und einer Vorrichtung zur hochgenauen Zeitmessung mit Systemen deren Bandbreite unterhalb der Bandbreite der gewünschten zeitlichen Auflösung liegt. Hierbei gilt, dass mit relativ flachen Triggersignalflanken eine zeitliche Auflösung eines Triggerereignisses im Bereich eines Hundertstel der Flankenanstiegszeit erreicht werden soll.

In einem Messsystem beträgt der Systemtakt z. B. 10 GHz. Es können hierbei Flanken mit einer maximalen Anstiegsgeschwindigkeit von z. B. 10mV/ps realisiert werden. Die gewünschte zeitliche Auflösung soll unter einem Hundertstel der Taktperiode liegen und soll damit kleiner als z. B. 1ps sein. Die zur Verfügung stehende Bandbreite des Systems ist dann maximal 20GHz.

Die Zeitmessung eines Triggerereignisses soll hier bezogen auf eine feste Taktreferenz erfolgen. Dieser Systemtakt bildet somit das Zeitnormal des Systems. Die meisten bisherigen Zeitmessverfahren basieren darauf, dass die Zeitmessung mit der Triggersignalflanke beginnt und mit dem Auftreten einer folgenden Taktflanke endet. Um den Beginn und das Ende der Zeitmessung genau festlegen zu können, setzt dieses voraus, dass die entsprechenden Trigger- bzw. Taktflanken eine sehr große Steilheit haben.

Wird das hier beschriebene erfindungsgemäße Verfahren genutzt, so kann auch mit relativ flachen Triggerflanken eine genaue Zeitmessung realisiert werden. Eine Zeitmessung wird hierbei auf eine Phasenmessung der Kreuzkorrelationsfunktion (CCF) einer Triggersignalfunktion mit dem Systemtakt zurückgeführt. Hierbei wird aus einer Triggerflanke ein Signalzug erzeugt, das dem Systemtakt möglichst ähnlich ist und dessen Länge in der Größenordnung einer Taktperiode liegt. Da dieser Triggersignalzug in Form und Länge einer Periode des Systemtakts ähnlich ist, werden hier lediglich die gleichen Bandbreiten benötigt, die auch für die Bereitstellung und Verarbeitung des Systemtakts notwendig sind. Daraus folgt, dass auch die Triggerflanken nicht steiler sein müssen, als die Flanken des Systemtakts.

Weiterhin gilt für Korrelationen, dass sich der Signal-Rauschabstand mit steigender Korrelationslänge verbessert. Insofern ist bezogen auf den Systemtakt ein relativ langes Triggersignal eher förderlich. Die Operation der Berechnung der Kreuzkorrelation wird hier vorzugsweise mit analogen Schaltungselementen realisiert.

Ausführungsbeispiele der Erfindung werden nachfolgend unter Bezugnahme auf die Zeichnung erläutert. In der Zeichnung zeigen:

Fig. 1      den prinzipiellen Aufbau eines Messsystems mit zeitlicher Synchronisation des empfangenen Signals;

Fig. 2      den prinzipiellen Aufbau eines Zeitmesssystems basierend auf einem Systemtakt als Zeitnormal;

Fig. 3      untersuchte Triggersignalformen s(t) normiert auf ein gleiches Maximum des Signals;

Fig. 4      das Spektrum der untersuchten Triggersignalformen;

Fig. 5      ein Blockschaltbild des Triggerzeitdetektors gemäß eines ersten Ausführungsbeispiels, der mit Hilfe der Kreuzkorrelation des Systemtaktes und einer bekannten Triggerfunktion arbeitet;

Fig. 6    ein Blockschaltbild des Eingangskomparators nach Fig. 5 einschließlich der Steuersignale und Begrenzerverstärker;

Fig. 7    ein Blockschaltbild des Triggerzeitdetektors gemäß eines zweiten Ausführungsbeispiels, der mit Hilfe der Kreuzkorrelation des Systemtaktes und einer bekannten Triggerfunktion arbeitet;

Fig. 8    ein Detail der Fig. 7;

Fig. 9    das Detail der Fig. 7 in einer Abwandlung gemäß eines dritten Ausführungsbeispiels;

Fig. 10    das Detail der Fig. 7 in einer Abwandlung gemäß eines vierten Ausführungsbeispiels und

Fig. 11    ein Blockschaltbild des Eingangskomparators nach Fig. 7.

Zunächst sollen die Signaleigenschaften der Signale betrachtet werden. Die Kreuzkorrelationseigenschaften zwischen Systemtakt und Triggersignal sollen möglichst gut sein. Für einen sinusförmigen Takt bedeutet dies, dass die Triggersignalform einem Ausschnitt aus einem Sinus-Signal möglichst ähnlich sein sollte. Da die Phase der Kreuzkorrelationsfunktion für die Basis der Zeitmessung dient, muss die Operation sowohl für den Realteil als auch für den Imaginärteil des Systemtakts durchgeführt werden. Dies setzt voraus, dass die Form des Triggersignals für beide Zweige gleich ist. Die Korrelationslänge bestimmt den Signal/Rausch-Abstand. Realistisch ist hier ein Wert zwischen einer halben und einer ganzen Taktperiode.

Zunächst erfolgt eine theoretische Herleitung einer günstigen Signalform für den Triggerpuls. Die Kreuzkorrelationsfunktion (CCF) zweier Signale g(t) und s(t) lässt sich wie folgt berechnen:

$$CCF = \int_{-\infty}^{\infty} s(t) \cdot g(t - \tau) dt$$

Es gilt:

CCF    - Kreuzkorrelationsfunktion
g(t) -    Systemtakt s(t) - Signalform des Triggerimpulses
$\tau$    - zeitliche Verschiebung des Triggersignals bezogen auf den Zeitpunkt der Nullphase des Systemtaktes

Für den Systemtakt (g(t)) wird nun ein komplexer Drehzeiger angenommen. Dieser kann in Hardware aus einem rein reellen Takt durch einen 90° Hybridkoppler erzeugt werden.

$$g(t) = \exp(j\omega t) = \cos(\omega t) + j\sin(\omega t) \quad | \quad \omega = \frac{2\pi}{T}$$

Es gilt:

$\omega$    - Kreisfrequenz des Systemtaktes
T    - Periodendauer des Systemtaktes

Im Falle eines Drehzeigers lässt sich eine Zeitdifferenz ($\tau$) im Argument der Funktion g(t) auch als Phasendifferenz ($\phi_0$) des Funktionswertes ausdrücken.

$$g(t-\tau) = \exp(j\omega\{t-\tau\}) = \exp(j\{\omega t - \varphi_0\}) = \cos(\omega t - \varphi_0) + j \cdot \sin(\omega t - \varphi_0) \quad | \quad \varphi_0 = 2\pi\frac{\tau}{T}$$

$$g(t-\tau) = \exp(j\omega t)\cdot\exp(-j\varphi_0) = g(t)\cdot\exp(-j\varphi_0)$$

Es gilt:

$\tau$      - zeitliche Verschiebung des Triggersignals bezogen auf den Zeitpunkt der Nullphase des Systemtaktes
$\phi_0$   - Phase des Systemtakts zum Zeitpunkt des Auftreten des Triggersignals.

Mit der obigen Gleichung lässt sich die Kreuzkorrelation wie folgt schreiben:

$$CCF = \int_{-\infty}^{\infty} s(t)\cdot g(t-\tau)\,dt = \exp(-j\varphi_0)\cdot\int_{-\infty}^{\infty} s(t)\cdot g(t)\,dt =$$

$$= \exp\left(j\cdot 2\pi\frac{\tau}{T}\right)\cdot\int_{-\infty}^{\infty} s(t)\cdot\exp(-j\omega t)\,dt$$

Für die Bestimmung des Triggerzeitpunkts bezogen auf den Systemtakt soll nun die Phase der Kreuzkorrelationsfunktion ausgewertet werden.

$$\varphi_{CCF}(CCF) = \varphi_{CCF}\left[\exp(-j\varphi_0)\cdot\int_{-\infty}^{\infty} s(t)\cdot\exp(j\omega t)\,dt\right] = \varphi_{CCF}\left[\exp(-j\varphi_0)\cdot h(\omega)\right]$$

$$h(\omega) = \int_{-\infty}^{\infty} s(t)\cdot\exp(j\omega t)\,dt$$

Der Ausdruck des komplexen Integrals $h(\omega)$ innerhalb der CCF entspricht dem Wert des Fourier-Integrals der Funktion $s(t)$ an der Frequenz (F) des Systemtakts mit:

$$F = \frac{\omega}{2\pi} = \frac{1}{T} \quad | \quad h(\omega) = \int_{-\infty}^{\infty} s(t)\cdot\exp(j\omega t)\,dt$$

Jede komplexe Zahl, so auch $h(\omega)$, lässt sich in Betrag und Phase zerlegen.

$$h(\omega) = |h(\omega)|\cdot\exp\{j\cdot\varphi_h(h(\omega))\}$$

Die Phase der Kreuzkorrelationsfunktion berechnet sich somit aus der Summe aus dem von $\tau$ abhängigen Phasenwert ($\phi_0$) und einem konstanten Phasenwert ($\phi_h$) der Fouriertransformierten von $s(t)$. Das Signal/RauschVerhältnis SNR dieses Phasenwertes wird durch den Betrag der Funktion $|h(\omega)|$ bestimmt. Dies entspricht dem Betrag der Fouriertransformierten von $s(t)$ an der Stelle $F=1/T$.

$$\varphi_{CCF}(CCF) = \varphi_{CCF}\left[\exp\{-j\varphi_0\} \cdot |h(\omega)| \cdot \exp\{j \cdot \varphi_h(h(\omega))\}\right] =$$
$$= \varphi_{CCF}\left[\exp\{\varphi_h - \varphi_0\} \cdot |h(\omega)|\right]$$

$$\varphi_{CCF}(CCF) = \{\varphi_h - \varphi_0\} = \left\{\varphi_h - 2\pi\frac{\tau}{T}\right\}$$

Aus dieser Gleichung lässt sich nun der Wert für die relative Zeitabweichung des Triggersignals zum Systemtakt $\tau$ bestimmen:

$$\tau = \frac{T}{2\pi}\left\{\varphi_h - \varphi_{CCF}[CCF]\right\} = \frac{T}{2\pi}\left\{\varphi_h - \varphi_{CCF}\left[\int_{-\infty}^{\infty} s(t) \cdot g(t-\tau)dt\right]\right\}$$

Auf die Realisierung der Kreuzkorrelation (CCF) in einem analogen Chip wird noch eingegangen.

Wie ersichtlich, hängt das Signal zu Rauschverhältnis SNR der Messung maßgeblich von der Form des Triggersignals s(t) ab. Zur Bewertung einer günstigen Form sollte der Betrag der Fouriertransformierten von s(t) an der Frequenz des Systemtakts $|h(\omega)|$ herangezogen werden.

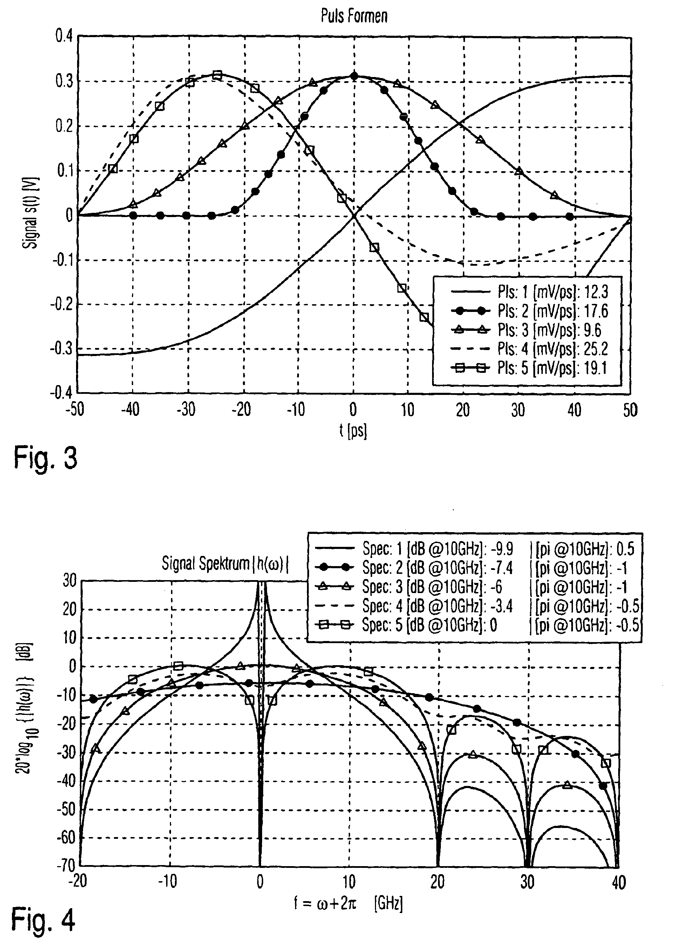

In Fig. 3 werden verschiedene mögliche Triggerpulsformen gezeigt und deren Spektren in Fig. 4 miteinander verglichen. Ausgehend von einer einfachen Flanke (Spec:1) bis hin zu einer gedämpften Sinus-Schwingung (Spec:5) lassen sich diese Signalformen in einem analogen Chip realisieren. Der Wert der größten Steilheit des Signals ist in der Legende angegeben. Hierzu wurde angenommen, dass der realisierbare Signalhub ca. +/- 300mV beträgt.

Anhand des Spektrums der Fig. 4 ist ersichtlich, dass eine einfache Triggerflanke (Spec:1) die schlechtesten Korrelationseigenschaften besitzt. Bei 10GHz beträgt hier die relative Leistung des ca. -10dB. Erwartungsgemäß hat ein Sinus-Signal der Frequenz 10GHz die besten Korrelationseigenschaften. Bei 10GHz beträgt hier die relative Leistung 0dB. Die Realisierung eines ungedämpften Sinussignals von 10GHz, das mit dem Auftreten des Triggerereignisses beginnt, ist jedoch sehr schwierig. Mit den Signalformen Spec 2 bis Spec 4 wurden nun realisierbare Signalformen untersucht, die in ihren Korrelationseigenschaften besser als eine einfache Signalflanke sind. Als Randbedingung gilt hierbei, dass die maximale Flankensteilheit in der Größenordnung von 15mV/ps liegt. Es zeigt sich, dass ein einfacher Gaußpuls (Spec 2 und Spec 3), der durch Differenzieren einer Flanke erzeugt werden kann, schon wesentlich bessere Korrelationseigenschaften besitzt. Die Breite des Pulses hat einen geringen Einfluss auf die Korrelationseigenschaft, so lange die Länge einer Taktperiode nicht überschritten wird. Noch bessere Korrelationseigenschaften würden sich ergeben, wenn statt eines Pulses ein gedämpfter Sinus verwendet wird. Hier spielt auch die Frequenz eine untergeordnete Rolle, solange sie größer als die halbe Taktfrequenz ist. Eine solche Kurvenform kann durch Anstoßen eines Schwingkreises mit schlechter Güte (Q = [2 .. 4]) erreicht werden.

Bei allen Signalformen ist zu beachten, dass die Signalbreiten klein genug gehalten werden. Wird das Signal breiter als eine Taktperiode, so wandert die Nullstelle im Spektrum von derzeit 20GHz auf 10GHz. Dann ist überhaupt keine Kreuzkorrelation mit ausreichender Signalamplitude mehr möglich.

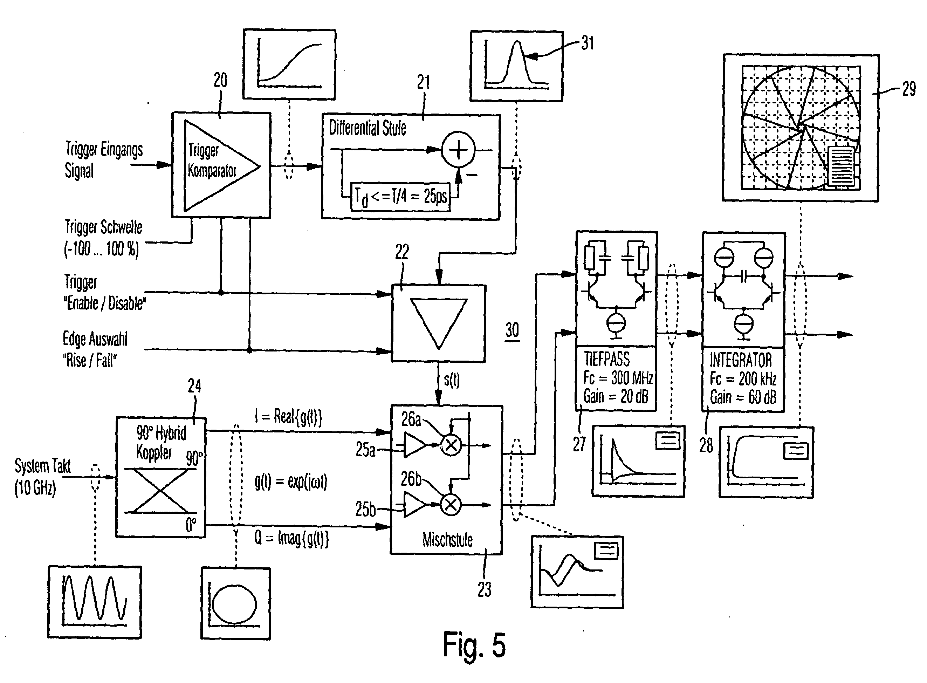

Fig. 5 zeigt ein erstes Ausführungsbeispiel der erfindungsgemäßen Vorrichtung. Ein Eingangssignal wird einem Triggerkomparator 20 zugeführt, der den Pegel des Eingangssignals mit einem Trigger-Schwellwert vergleicht und nur dann durchschaltet, wenn der Schwellwert überschritten ist. Dem Eingangskomparator folgt vorzugsweise ein in Fig. 5 nicht gezeigtes RS Flip Flop um eine konstante möglichst große Steilheit des Triggersignals zu realisieren. Dann liegt am RS Flip Flop ein "Trigger-RESET" Signal an, mit dem das Flip Flop zurückgesetzt bzw. deaktiviert werden kann. Des weiteren wird ein "Edge Select"-Signal zugeführt, mit welchem eine Auswahl zwischen der ansteigenden Flanke und der abfallenden Flanke des Trigger-Signals getroffen werden kann.

An den Trigger-Komparator 20 schließt sich ein Differenzierer 21 an, der eine analoge Differenzierung des Eingangs-Signals vornimmt. Das differenzierte Eingangssignal wird dann über einen Verstärker 22 einem analogen, komplexen Mischer 23 zugeführt. Durch das Differenzieren entsteht aus einer einfachen Signalflanke ein gaußähnlicher Puls 31.

Der System-Takt wird in einem 90° Hybrid-Koppler in seine Realteil-Komponente I und seine Imaginärteil-Komponente Q zerlegt und dann dem komplexen Mischer 23 zugeführt. Der komplexe Mischer 23 hat jeweils einen Vorverstärker 25a bzw. 25b für die Realteil-Komponente I und die Imaginärteil-Komponente Q sowie jeweils eine Misch-Stufe 26a bzw. 26b für die Realteil-Komponente I und die Imaginärteil-Komponente Q. Das komplexe Ausgangssignal des Mischers 23 wird über einen nicht zwingend notwendigen, optionalen Tiefpass 27 einem analogen Integrator 28 zugeführt. Das Ausgangssignal des Integrators 28 wird über in Fig. 5 nicht dargestellte Analog/Digial-Wandler digitalisiert und dann digital weiterverarbeitet und schließt sich auf einer Anzeigeeinrichtung (Display) 29 in der I/Q-Ebene dargestellt.

Bei dem Ausführungsbeispiel nach Fig. 5 besteht der Kreuzkorrelator somit aus dem analogen Komplexmischer 23, dem Tiefpass 27 und dem Integrator 28.

Wie vorstehend beschrieben, lässt sich die Synchronisation des Triggersignals zum Systemtakt durch ein Kreuzkorrelationsintegral bestimmen.

$$\tau = \frac{T}{2\pi}\left\{\varphi_h - \varphi_{CCF}\left[\int_{-\infty}^{\infty} s(t) \cdot g(t-\tau)dt\right]\right\}$$

Es gilt:

$\tau$    - zeitliche Verschiebung des Triggersignals bezogen auf den Zeitpunkt der Nullphase des Systemtaktes

T    - Periodendauer des Systemtaktes

$\phi_h$    - konstante Phasendifferenz, die durch die Signalform des Triggersignals bestimmt ist.

$\phi_{CCF}$    - Phase der Kreuzkorrelationsfunktion

Die Aufgabe besteht nun darin, dieses Korrelationsintegral vorzugsweise durch eine analoge Schaltung zu bestimmen. Unter der Annahme, dass das Triggersignal [s(t)] zeitlich begrenzt ist, können die Integrationsgrenzen auf den Zeitbereich begrenzt werden, in dem s(t) ungleich Null ist. Dieses ist für alle untersuchten Triggersignalformen außer der einfachen Flanke möglich.

$$\tau = \frac{T}{2\pi}\left\{\varphi_h - \varphi_{CCF}\left[\int_{-\frac{T}{2}}^{\frac{T}{2}} s(t) \cdot g(t-\tau)dt\right]\right\}$$

Damit kann gewährleistet werden, dass die Auswertung des Triggerereignisses in endlicher Zeit abgeschlossen werden kann.

Ein Korrelationsintegral besteht aus einer Multiplikation zweier Signale und einer anschließenden Integration. Damit besteht für eine Schaltung aus analogen Schaltelementen ebenfalls die Aufgabe der Realisierung der analogen Operationen, Bildung des Produktes zweier Signale und die anschließende Integration.

Beide Operationen lassen sich in analoger Hardware relativ leicht realisieren: durch eine Multiplikation durch den Mischer 23 und die Integration der Zwischenfrequenz durch den analogen Integrator 28, was in Fig. 5 veranschaulicht ist. Da die Integrationszeit begrenzt ist, kann der Integrationsverstärker auch als Tiefpass mit sehr kleiner Eckfrequenz bezogen auf die Taktfrequenz ausgeführt sein. Es kann gezeigt werden, dass die Phase des Signals nach der Integration proportional zum Zeitversatz des Auftretens des Triggerereignisses ist.

Fig. 5 zeigt das IQ-Diagramm am Ausgang des Integrators 28, das zur Phase von acht gleichmäßig verteilten Triggerereignissen auch acht verschiedene Phasenwerte enthält, die mit den erwarteten Referenzwerten übereinstimmen. Mögliche Fehlerquelle sind hier im 90° Hybrid-Koppler und in der Symmetrie des I-bzw. Q-Zweiges zu suchen. Bei ungleichen Verstärkungen in beiden Zweigen, bzw. bei einem unsymmetrischen Hybrid Koppler, äußern sich die Fehler in Form eines IQ - Verstärkungsfehlers bzw. eines Quadratur Fehlers. Diese Fehlerarten müssen durch die Kalibrierung abgefangen werden.

Um eine eindeutige Flanke zu realisieren, ist zunächst der Komparator 20 vorteilhaft, der aus dem Vergleich des Eingangssignals mit einem Referenzwert diese Flanke erzeugt. Anschließend wird das in dem Differenzierer 21 differenzierte Triggersignal durch den Begrenzerverstärker 22 weiter verstärkt, um die Flankesteilheit so groß wie möglich zu machen. Der Begrenzerverstärker 22 sollte vorzugsweise zusätzlich zwei Steuereingänge enthalten: Einen Eingang zur Flankenauswahl zur Steuerung der positiven bzw. negativen Flanke und einen Enable Eingang um nachfolgende Triggerlogik bei mehrfach Triggern zu sperren und erst wieder freizugeben, wenn die Ergebnisse des Triggerereignisses ausgelesen wurden.

Der Begrenzerverstärker 22 wurde basierend auf konkreten Transistormodellen simuliert. Die durchgeführten Simulationen zeigen, dass hiermit Flankensteilheiten von ca. 30 - 40 ps erreicht werden können. Das ist für die Detektion nach der Kreuz Korrelation Methode ausreichend.

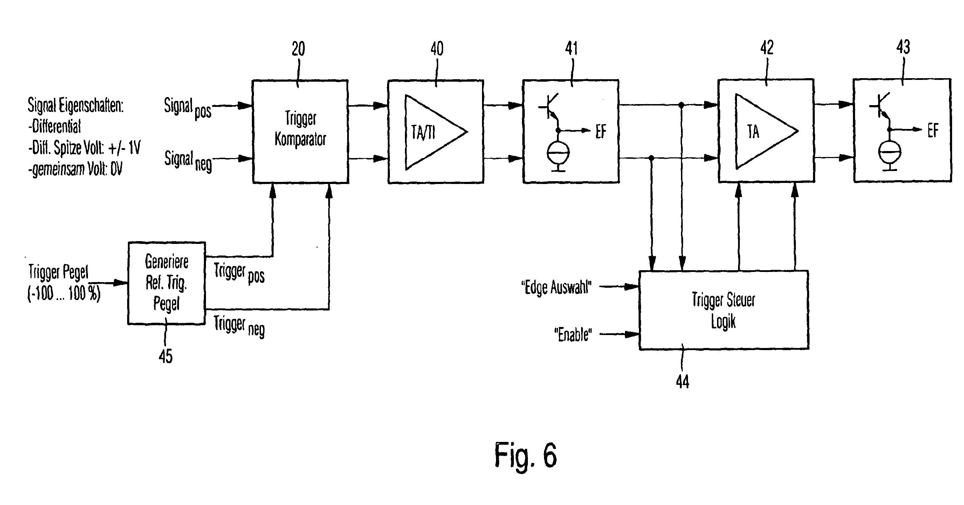

Das in Fig. 6 gezeigte Blockschaltbild wurde zur Prüfung der Realisierbarkeit simuliert. Es besteht aus dem Trigger-Komparator 20, dem Verstärker 40, dem Emitter-Folger 41, dem weiteren Verstärker 42 und dem weiteren Emitter-Folger 43. Die positive Triggerflanke Trigger$_{pos}$ und die negative Triggerflanke Trigger$_{neg}$ des Triggersignals wird in dem Block 45 generiert. Die Logik der Triggersteuerung ist in Block 44 enthalten.

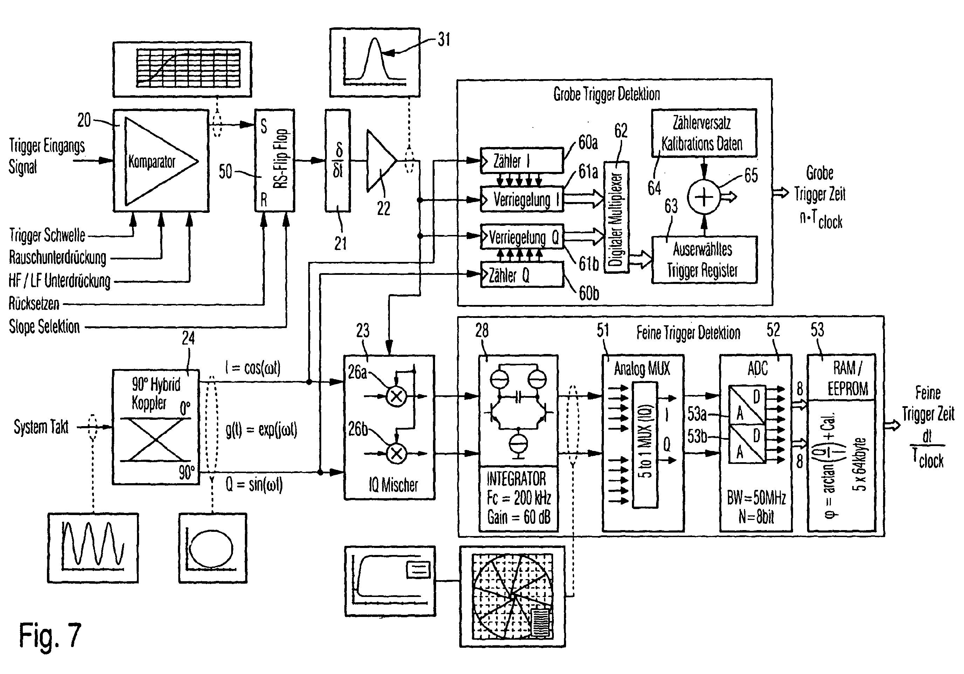

Fig. 7 zeigt ein zweites Ausführungsbeispiel der erfindungsgemäßen Vorrichtung. Bereits anhand von Fig. 5 beschriebene Elemente sind mit übereinstimmenden Bezugszeichen versehen, so dass sich insoweit eine wiederholende Beschreibung erübrigt.

Gegenüber dem in Fig. 5 dargestellten Ausführungsbeispiel ist zwischen dem Trigger-Komparator 20 und dem Differenzierer 21 ein RS-Flip Flop 50 angeordnet. Außerdem ist die Weiterverarbeitung nach dem Integrator 28 dargestellt. Im dargestellten Ausführungsbeispiel ist dort ein analoger Multiplexer 51 vorhanden, der eine Umschaltung zwischen mehreren Auswertekanälen ermöglicht und bei einer einkanaligen Ausführung natürlich nicht notwendig ist. Daran schließt sich eine Analog/Digital-Wandeleinheit 52 an, die einen ersten Analog/DigitalWandler 53a für die Realteil-Komponente I und einen zweiten Analog/Digital-Wandler 53b für die Imaginärteil-Komponente Q beinhaltet.

Das Ausgangssignal des Differenziergliedes 21 wird über einen Verstärker 22 auf das RF Tor eines komplexen Mischers 23 gegeben. Am LO Tor des komplexen Mischers 23 liegt das komplexe Signal des Systemtakts an. Dieses kann zum Beispiel durch einen 90° Hybridkoppler 24 erzeugt werden. Der Mischer 23 führt somit eine komplexe Multiplikation des gaußähnlichen Signals vom RF Tor mit dem komplexen Drehzeiger des LO Tores durch. Das resultierende Ausgangssignal entspricht somit der in im Kreuzkorrelationsintegral geforderten analogen Multiplikation:

$$s(t) \cdot \exp(j\omega t) \ .$$

Das dann eventuell noch analog zu Fig. 5 folgende Tiefpassfilter 27 und das Integrationsfilter 28 realisieren eine analoge Integration des Signals, so dass am Ausgang des Integrationsfilters 28 der analoge komplexe Wert der Kreuzkorrelation vorliegt.

$$\int s(t) \cdot \exp(j\omega t) \, dt$$

Das aktive Tiefpassfilter dient in diesem Fall der Unterdrückung von Mischersignalanteilen hoher Frequenzen des Mischerausgangs und verstärkt gleichzeitig den Nutzanteil des Signals.

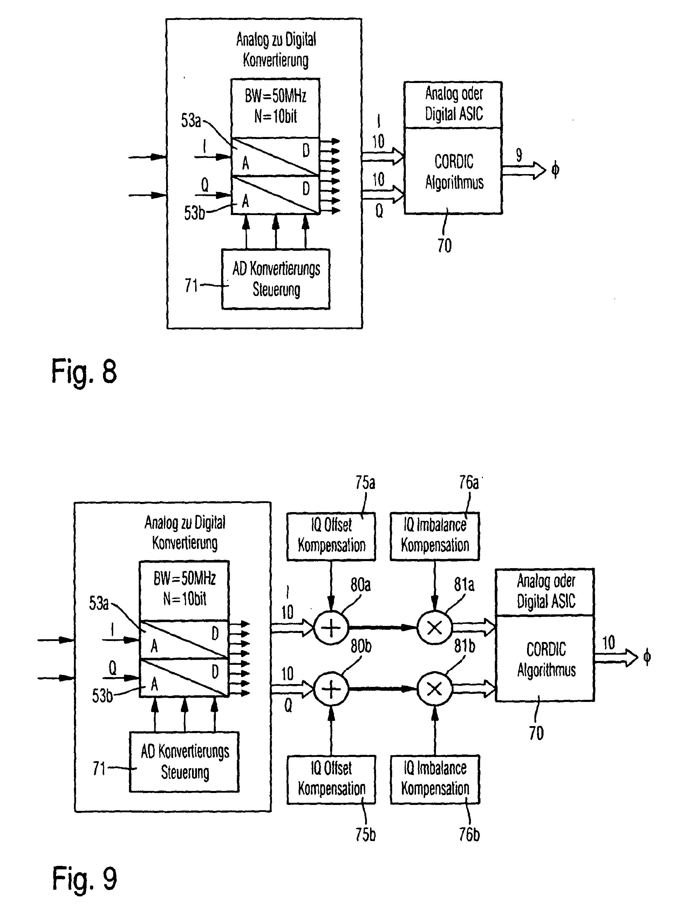

Die von der Analog/Digital-Wandlereinheit 52 erzeugten Digitalwerte werden in einem Speicher 53 abgelegt und in einer anhand der Fig. 8 und 9 noch näher zu beschreibenden Weise in die Phasen-Werte umgerechnet. Hieraus lässt sich dann wie vorstehend beschrieben die feine Zeitverzögerung dt bezogen auf die Taktperiode T$_{clock}$ bestimmen.

Zur Vervollständigung ist in Fig. 7 noch die Detektion der groben Zeitverzögerung n·T$_{clock}$ in Einheiten der Taktperiode T$_{clock}$ dargestellt. Hierzu ist für die Realteil-Komponente I ein erster Zähler 60a und für die Imaginärteil-Komponente Q ein zweiter Zähler 60b vorhanden. Der aktuelle Zählerstand des ersten Zählers 60a wird einer ersten Verriegelungsschaltung 61a übergeben, während der Zählerstand des zweiten Zählers 60b einer zweiten Verriegelungsschaltung 61b übergeben wird. Die Verriegelungsschaltungen 61a und 61b werden durch das Eingangssignal verriegelt bzw. getriggert und das Ergebnis wird über einen digitalen Multiplexer einem Triggerregister 63 übergeben. Der digitale Multiplexer 62 ist nur notwendig, wenn mehrere Kanäle gleichzeitig beobachtet werden sollen. Eventuelle Kalibrierungs-Daten können in einem Offset-Register 64 vorhanden sein und dem Ergebnis über einen Addierer 64 zugefügt werden. Am Ausgang des Addierers 65 steht dann die grobe Zeitverzögerung in Einheiten der Taktperiode T$_{clock}$ zur Verfügung.

Gemäß Fig. 7 wird das Eingangssignal zunächst über den Eingangskomparator 20 verstärkt und mit der Triggerschwelle verglichen. Das RS Flip Flop 50 erzeugt daraus eine Flanke mit immer gleicher Steigung. Üblicherweise beträgt die Flankenanstiegszeit ca. z. B. 50ps. Diese Flanke soll nun um einen bestimmten einstellbaren Wert verzögert werden. Die Größe dieser Verzögerung hängt von den Laufzeitdifferenzen der Signalpfade im System ab. Die differentiellen Laufzeitverzögerungen zwischen den Kanälen sollen während der Kalibrierung gemessen werden und im analogen Zweig kompensiert werden. Zunächst wird die eingangs erzeugte steile Flanke definiert verzögert. Hier kann vorteilhaft ein Tiefpass 2. Ordnung verwendet werden. Die Sprungantwort eines solchen Filters ist in einem bestimmten Pegelbereich weitgehend linear. Hier beträgt der Linearitätsfehler maximal 10 %. Die so entstandene Kurve wird dann mittels eines weiteren nicht dargestellten Triggerkomparators mit einer einstellbaren Triggerschwelle verglichen. Der einzustellende Wert ergibt sich aus einer Kennlinie, die im Wesentlichen von der Sprungantwort des Tiefpassfilters abhängt. Am Ausgang des zweiten Komparators ergibt sich nun eine vom D/A-Wandler-Pegel abhängige Verzögerung.

Das RS Flip Flop 50 kann über eine Steuerleitung ("Slope Select") für positive Triggerflanken als auch für negative Triggerflanken konfiguriert werden: Über eine RESET Leitung kann das Flip Flop 50 wieder zurückgesetzt werden, um den Baustein für den Empfang des nächsten Triggerereignisses bereit zu machen. Der Baustein wird erst wieder freigegeben, wenn die Ergebnisse des Triggerereignisses ausgelesen wurden. Anschließend wird die Flanke am Ausgang des RS Flip Flops 50 durch das Differenzierglied 21 in einen gaußähnlichen Puls 31 umgewandelt.

Die einfachste Möglichkeit der Analog-Digitalumsetzung des komplexen Wertes nach dem Integrationsfilter sind zwei A/D-Wandler 53a und 53b. Für diese Funktionalität sind 50MHz A/D-Wandler ausreichend. Nun ist für die Auswertung des Triggerzeitpunkts die Phaseninformation die zu bestimmende Größe. Eine rechnerische Auswertung der I/Q Daten nach Betrag und Phase in einem externen Prozessor ist bei einer Datenrate von 50 MHz nur schwer möglich. Zur Lösung dieses Problems werden zwei Vorschläge gemacht.

Die in Fig. 8 gezeigte Möglichkeit besteht in der Nutzung des CORDIC Algorithmus z. B. im selben oder in einem nachgeschalteten ASIC 70. Die Steuerung der A/D-Wandler 53a und 53b erfolgt mit der Steuereinheit 71.

Zur Korrektur der im System durch IQ Verzerrung entstandenen Fehler werden beim Ausführungsbeispiel der Fig. 9 dem CORDIC Algorithmus je ein Addierer 80a bzw. 80b zur Kompensation des IQ-Offset 75a bzw. 75b und je ein Multiplikator 81a bzw. 81b zur Kompensation des IQ-Imbalance 76a bzw. 76b vorgeschaltet.

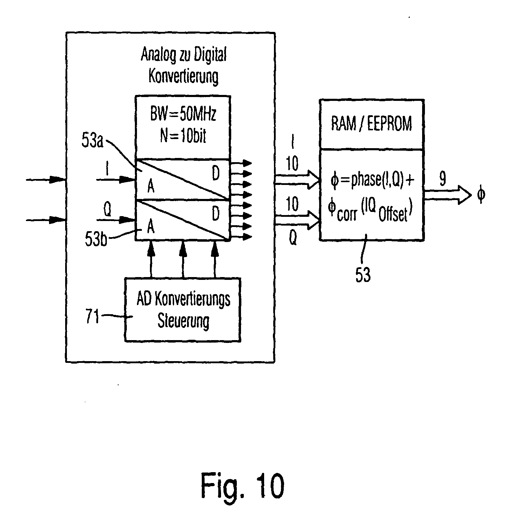

Die zweite Möglichkeit, die in Fig. 10 gezeigt ist, besteht im Nachschalten eines Speichers 53, mit einem zweidimensionalen Eingangsadressraum (I-10 Bit/Q-10 Bit → 2x10 Bit). In dem Speicher 53 werden nun die Phasenwerte der Eingangs I/Q-Werte Paare abgelegt. Die Größe des Adressraumes könnte bei gleicher Genauigkeit verkleinert werden, wenn eine Gradiententabelle zur linearen Interpolation benutzt wird. Der Vorteil besteht darin, dass in den Tabellen nach einer Kalibrierung die Fehlerwerte aus IQ-Offset und IQ-Imbalance berücksichtigt und korrigiert werden können.

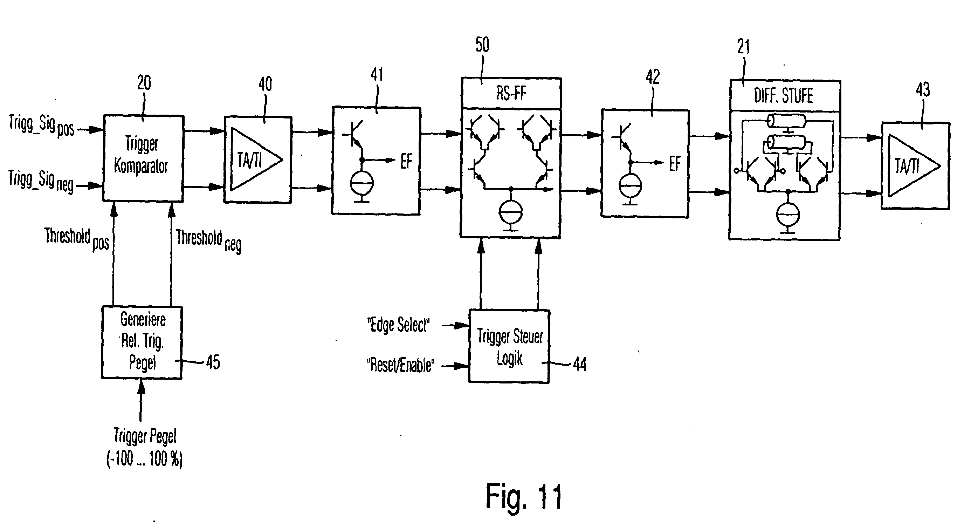

Das in Fig. 11 gezeigte Blockschaltbild des Eingangskomparators besteht aus dem Trigger-Komparator 20, dem Verstärker 40, dem Emitter-Folger 41, dem RS Flip Flop 50, einem weiteren Emitter-Folger 42, dem Differenzierglied 21 und einem abschließenden Verstärker 43. Alle Schaltungselemente sind in ECL-Technologie ausgeführt. Dementsprechend werden alle Signale differentiell geführt (pos bzw. neg). Im Block "Generiere Ref. Trig. Level" 45 wird der von außen eingestellte Referenzpegel in ein entsprechendes differentielles Signal (Threshold$_{pos}$/Threshold$_{neg}$) gewandelt. Dieses wird im Trigger-Komparator 20 mit dem Triggereingangssignal (Trig_Sig$_{pos}$/Trig_Sig$_{neg}$) verglichen.

Eine separate Steuerung 44 übernimmt die Konfiguration des RS Flip Flops 50. Hier wird eingestellt, ob auf eine positive oder eine negative Flanke getriggert werden soll ("EDGE/SELECT"). Des weiteren wird die Freigabe der Triggerfunktion ("ENABLE") bzw. das Rücksetzen des RS Flip Flops 50 ("RESET") ebenfalls durch diese Steuerung übernommen.

Das Differenzierglied 21 ist ebenfalls für differentielle Signale ausgelegt. Die Funktionalität kann hier durch das Subtrahieren eines laufzeitverzögerten Signals vom Eingangssignal erfolgen. Die Laufzeitverzögerung kann durch differentielle Verzögerungsleitungen erreicht werden. Die Länge dieser Verzögerungsleitungen bestimmt sich aus der Wellenlänge des Systemtakts (z. B. 10GHz) und beträgt ein Viertel der Wellenlänge des Systemtaktes. Die Subtraktion vom Eingangssignal erfolgt durch ein paarweises Vertauschen der verzögerten differentiellen Signale und eine anschließende analoge differentielle Additionsschaltung. Hier wird zu dem Eingangssignal ein verzögertes vorzeicheninvertiertes differentielles Signal hinzugefügt. Dadurch kann mit wenig Aufwand ein differentielles Differenzierglied mit reproduzierbar bestimmbarer Zeitkonstante realisiert werden.

Abschließend wird das differenzierte Signal durch den Verstärker 43 wieder verstärkt. Das Differenzierglied ist durch den Emitter-Folger 42 an den Ausgang des RS Flip Flops 50 angebunden.

Die Erfindung ist nicht auf die dargestellten Ausführungsbeispiele beschränkt. Alle beschriebenen und gezeichneten Merkmale sind im Rahmen der Erfindung beliebig miteinander kombinierbar. Bei einer einkanaligen Ausführung können die Multiplexer 51 und 62 entfallen. Unter anderem sind der Tiefpass 27 und der Differenzierer 21 nicht zwingend erforderlich.

## Patentansprüche

**1.** Verfahren zum Bestimmen der zeitlichen Lage eines analogen Triggersignals in Bezug auf ein analoges Taktsignal,
**dadurch gekennzeichnet,**
**dass** für eine Feinauflösung eine analoge Kreuzkorrelation (30) zwischen dem Triggersignal und Taktsignal durchgeführt wird und
**dass** die Kreuzkorrelation (30) eine analoge komplexe Mischung (23) des aufbereiteten Triggersignals und des aufbereiteten Taktsignals umfasst.

**2.** Verfahren nach Anspruch 1,
**dadurch gekennzeichnet,**
**dass** nach der analogen Mischung (23) eine analoge Integration (28) in einem Integrator durchgeführt wird.

**3.** Verfahren nach Anspruch 2,
**dadurch gekennzeichnet,**
**dass** zwischen der analogen Mischung (23) und der analogen Integration (28) eine Tiefpassfilterung (27) durchgeführt wird.

**4.** Verfahren nach einem der Ansprüche 1 bis 3,
**dadurch gekennzeichnet,**
**dass** das analoge Triggersignal vor der Mischung durch Differenzieren (21) in einem Differenzierer aufbereitet wird.

**5.** Verfahren nach Anspruch 4,
**dadurch gekennzeichnet,**
**dass** vor dem Differenzieren (21) ein Vergleich des Triggersignals mit einem Triggerschwellwert erfolgt.

**6.** Verfahren nach einem der Ansprüche 1 bis 5,
**dadurch gekennzeichnet,**
**dass** das analoge Taktsignal vor der Mischung (23) aufbereitet wird, indem es in seine Realteil-Komponente (I) und seine Imaginärteil-Komponente (Q) zerlegt wird.

**7.** Vorrichtung zum Bestimmen der zeitlichen Lage eines analogen Triggersignals in Bezug auf ein analoges Taktsignal,
**dadurch gekennzeichnet,**
**dass** ein analoger Kreuzkorrelator (30) für eine Feinauflösung eine analoge Kreuzkorrelation zwischen dem Triggersignal und Taktsignal durchführt und
**dass** der Kreuzkorrelator (30) einen analogen komplexen Mischer (23) aufweist, der das aufbereitete Triggersignal und das aufbereitete Taktsignal miteinander mischt.

**8.** Vorrichtung nach Anspruch 7,
**dadurch gekennzeichnet,**
**dass** der Kreuzkorrelator (30) einen analogen Integrator (28) aufweist, der dem analogen Mischer (23) nachgeschaltet ist.

**9.** Vorrichtung nach Anspruch 8,
**dadurch gekennzeichnet,**
**dass** zwischen dem analogen Mischer (23) und dem analogen Integrator (28) ein analoges Tiefpassfilter (27) angeordnet ist.

**10.** Vorrichtung nach einem der Ansprüche 7 bis 9,
**gekennzeichnet durch**
einen analogen Differenzierer (21), der das analoge Triggersignal differenziert, bevor es dem Mischer (23) zugeführt wird.

**11.** Vorrichtung nach einem der Ansprüche 7 bis 10,
**gekennzeichnet durch**
einen vor dem Mischer (23) angeordneten analogen Trigger-Komparator (20), der das analoge Triggersignal mit einem Triggerschwellwert vergleicht.

**12.** Vorrichtung nach einem der Ansprüche 7 bis 11,
**gekennzeichnet durch**
einen vor dem Mischer (23) angeordneten analogen Koppler (24), der das analoge Taktsignal vor der Mischung in seine Realteil-Komponente (I) und seine Imaginärteil-Komponente (Q) zerlegt.

**13.** Vorrichtung nach einem der Ansprüche 7 bis 12,
**dadurch gekennzeichnet,**
**dass** dem Kreuzkorrelator (30) jeweils ein Analog/DigitalWandler (53a; 53b) für die Realteil-Komponente (I) und die Imaginärteil-Komponente (Q) nachgeschaltet ist.

**14.** Vorrichtung nach Anspruch 13,
**dadurch gekennzeichnet,**
**dass** aus der digitalisierten Realteil-Komponente (I) und der digitalisierten Imaginärteil-Komponente (Q) der Phasenwinkel (φ) berechnet wird oder aus einer in einem Speicher (53) gespeicherten Tabelle ausgelesen wird.

**Claims**

1. Method for determining the temporal position of an analog trigger signal relative to an analog clock signal,
   **characterised in that**
   an analog cross correlation (30) between the trigger signal and the clock signal is implemented in order to achieve a fine resolution and that the cross correlation (30) comprises an analog, complex mixing (23) of the conditioned trigger signal and of the conditioned clock signal.

2. Method according to claim 1,
   **characterised in that**
   an analog integration (28) in an integrator is implemented after the analog mixing (23).

3. Method according to claim 2,
   **characterised in that**
   a low-pass filtering (27) is implemented between the analog mixing (23) and the analog integration (28).

4. Method according to any one of claims 1 to 3,
   **characterised in that**
   the analog trigger signal is conditioned before the mixing by differentiation (21) in a differential stage.

5. Method according to claim 4,
   **characterised in that**
   the trigger signal is compared with a trigger threshold value before the differentiation (21).

6. Method according to any one of claims 1 to 5,
   **characterised in that**
   the analog clock signal is conditioned before the mixing (23) by analysis into its real component (I) and its imaginary component (Q).

7. Device for determining the temporal position of an analog trigger signal relative to an analog clock signal,
   **characterised in that**
   an analog cross correlator (30) implements an analog cross correlation between the trigger signal and the clock signal in order to achieve a fine resolution and
   that the cross correlator (30) provides an analog complex mixer (23), which mixes the conditioned trigger signal and the conditioned clock signal with one another.

8. Device according to claim 7,
   **characterised in that**
   the cross correlator (30) provides an analog integrator (28), which is connected downstream of the analog mixer (23).

9. Device according to claim 8,
   **characterised in that**
   an analog low-pass filter (27) is disposed between the analog mixer (23) and the analog integrator (28).

10. Device according to any one of claims 7 to 9,
    **characterised by**
    an analog differential stage (21), which differentiates the analog trigger signal before it is supplied to the mixer (23).

11. Device according to any one of claims 7 to 10,
    **characterised by**
    an analog trigger comparator (20) disposed upstream of the mixer (23), which compares the analog trigger signal with a trigger-threshold value.

12. Device according to any one of claims 7 to 11,
    **characterised by**

an analog coupler (24) disposed upstream of the mixer (23), which analyses the analog clock signal into its real component (I) and its imaginary component (Q) before the mixing.

13. Device according to any one of claims 7 to 12,
   **characterised in that**
   an analog/digital converter (53a; 53b) for the real component (I) and for the imaginary component (Q) respectively is connected downstream of the cross correlator (30).

14. Device according to claim 13,
   **characterised in that**
   the phase angle ($\phi$) is calculated from the digitised real component (I) and the digitised imaginary component (Q) or read out from the table stored in a memory (53).

**Revendications**

1. Procédé pour déterminer la position temporelle d'un signal de déclenchement analogique par rapport à un signal d'horloge analogique,
   **caractérisé en ce que**
   une corrélation croisée analogique (30) entre le signal de déclenchement et le signal d'horloge est effectuée pour une résolution fine et
   en que la corrélation croisée (30) comprend un mélange complexe analogique (23) du signal de déclenchement traité et du signal d'horloge traité.

2. Procédé selon la revendication 1, **caractérisé en ce que**
   une intégration analogique (28) est effectuée dans un intégrateur après le mélange analogique (23).

3. Procédé selon la revendication 2, **caractérisé en ce que**
   un filtrage passe-bas (27) est effectué entre le mélange analogique (23) et l'intégration analogique (28).

4. Procédé selon l'une des revendications 1 à 3, **caractérisé en ce que**
   le signal de déclenchement analogique est traité avant le mélange par différenciation (21) dans un différenciateur.

5. Procédé selon la revendication 4, **caractérisé en ce que**
   une comparaison du signal analogique avec une valeur de seuil de déclenchement se produit avant la différenciation (21).

6. Procédé selon l'une des revendications 1 à 5, **caractérisé en ce que**
   le signal d'horloge analogique est traité avant le mélange (23), alors qu'il est fractionné en sa composante partie réelle (I) et sa composante partie imaginaire (Q).

7. Dispositif pour déterminer la position temporelle d'un signal de déclenchement analogique par rapport à un signal d'horloge analogique,
   **caractérisé en ce que**
   un corrélateur croisé analogique (30) effectue une corrélation croisée analogique entre le signal de déclenchement et le signal d'horloge pour une résolution fine et
   **en ce que** le corrélateur croisé (30) comporte un mélangeur complexe analogique (23), qui mélange ensemble le signal de déclenchement traité et le signal d'horloge traité.

8. Dispositif selon la revendication 7, **caractérisé en ce que**
   le corrélateur croisé (30) comporte un intégrateur analogique (28), qui est placé en aval du mélangeur analogique (23).

9. Dispositif selon la revendication 8, **caractérisé en ce que**
   un filtre passe-bas analogique (27) est placé entre le mélangeur analogique (23) et l'intégrateur analogique (28).

10. Dispositif selon l'une des revendications 7 à 9, **caractérisé par**
   un différenciateur analogique (21), qui différencie le signal de déclenchement analogique, avant qu'il soit délivré au mélangeur (23).

11. Dispositif selon l'une des revendications 7 à 10, **caractérisé par**
un comparateur de déclenchement analogique (20) disposé avant le mélangeur (23), comparateur qui compare le signal de déclenchement analogique à une valeur de seuil de déclenchement.

12. Dispositif selon l'une des revendications 7 à 11, **caractérisé par**
un coupleur analogique (24) disposé avant le mélangeur (23), coupleur qui fractionne le signal d'horloge analogique en sa composante partie réelle (I) et en sa composante partie imaginaire (Q) avant le mélange.

13. Dispositif selon l'une des revendications 7 à 12, **caractérisé en ce que**
un convertisseur analogique/numérique respectif (53a ; 53b) pour la composante partie réelle (I) et la composante partie imaginaire (Q) est placé en aval du corrélateur croisé (30).

14. Dispositif selon la revendication 13, **caractérisé en que**
l'angle de phase ($\phi$) est calculé à partir de la composante partie réelle numérisée (I) et de la composante partie imaginaire numérisée (Q) ou est lu à partir d'un tableau mémorisé dans une mémoire (53).

**Fig. 1**
(Stand der Technik)

Display Spur Daten — 5

Zeitabgleich der aufgenommenen Daten — 4

Aufnahme Puffer — 3

A/D — 7

Zeit Messung und Synchronisations System — 6

Analoge Messung Front End — 1

Auswahl der Trigger Quelle — 2

DUT ~ — 8

Rec(t)

Trg(t)

externer Trigger

**Fig. 2**

Zeitmessungs- und Synchronisations-System

Grobe Zeitmessung
$\Delta t_{coarse} = n*T_{clock}$   $n = [1, 2, 3 ...]$ — 10

Feine Zeitmessung
$\Delta t_{fine} = \alpha*T_{clock}$   $\alpha = [0 .... 1]$ — 11

Berechnung der totalen Zeit- Differenz
$\Delta t_{total} = \Delta t_{coarse} + \Delta t_{fine}$ — 12

Zeit- Differenz

Trigger

System Takt

Fig. 3

Fig. 4

Fig. 5

Fig. 6

Fig. 7

EP 2 039 008 B1

Analog zu Digital
Konvertierung

BW=50MHz
N=10bit

53a

I

A    D

Q

A    D

53b

AD Konvertierungs
Steuerung

71

I
10

Q
10

Analog oder
Digital ASIC

CORDIC
Algorithmus

70

9    φ

## Fig. 8

Analog zu Digital
Konvertierung

BW=50MHz
N=10bit

53a

I

A    D

Q

A    D

53b

AD Konvertierungs
Steuerung

71

I
10

Q
10

75a          76a

IQ Offset
Kompensation

IQ Imbalance
Kompensation

80a          81a

+    ×

80b          81b

+    ×

IQ Offset
Kompensation

IQ Imbalance
Kompensation

75b          76b

Analog oder
Digital ASIC

CORDIC
Algorithmus

70

10    φ

## Fig. 9

**Analog zu Digital Konvertierung**

BW=50MHz
N=10bit

53a

I
A — D

Q
A — D

53b

AD Konvertierungs Steuerung

71

RAM / EEPROM

I
10

10
Q

$\phi = phase(I,Q) + \phi_{corr}(IQ_{Offset})$

9

$\phi$

53

Fig. 10

20

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20050024120 A1
- EP 0529875 A2
- EP 1496410 A1